# EUROPEAN PATENT APPLICATION

(11) **EP 2 390 702 A1**
(43) Date of publication of application: **30.11.2011**
(21) Application number: 10014209.0
(22) Date of filing: 02.11.2010
(51) Int. Cl.: G02B 7/02, H01L 27/146, H01L 31/0203, H01L 31/0232

(54) **Camera module and fabrication method thereof**

(30) Priority: 27.05.2010 US 788612
(71) Applicant: VisEra Technologies Company Limited, Hsinchu 300-78 (TW); OmniVision Technologies, Inc., Santa Clara, CA 95054 (US)
(72) Inventor: Lin, Tzy-Ying, Hsinchu City 300 Taiwan (CN); Cheng, Chieh-Yuan, Hsinchu City 300 Tawain (CN); Lin, Hung-Yeh, Luodong Township Yilan County 265 Taiwan (CN)
(74) Representative: Wagner, Bernhard Peter

(57) **Abstract**

A camera module is disclosed. The camera module includes an imager sensor device comprising a microlens array. A lens set overlies the imager sensor device. A dry film type photoresist spacer is interposed between the imager sensor device and the lens set, wherein the dry film type photoresist spacer has an opening above the microlens array. A fabrication method of the camera module is also disclosed.

## Description

### Field of the Invention

The invention relates to image sensor technology and more particularly to a camera module using photosensitive-type spacers.

### Description of the Related Art

Charge coupled devices (CCD) and complementary metal oxide semiconductor (CMOS) image sensor devices are widely used in digital imaging applications. Image capture technology is well known to consumers due to the proliferation of devices employing camera modules, including digital cameras, digital video recorders, image capture capable mobile phones, monitors, and other camera-equipped products.

A conventional camera module includes an image sensor device (i.e. an image pickup or capturing device) and one or more lens set(s). The lens sets are disposed on the image sensor device and arranged in a stack so as to map the image of incident light rays onto the image sensor device. Glass spacers are typically disposed between the lens sets and between the image sensor device and the adjacent lens set by adherence, using adhesive materials (i.e. ultra-violet (UV) curing resin or thermo-hardening resin), wherein predetermined distances are maintained between the lens sets and between the image sensor device and the adjacent lens set, to obtain a desired focal distance from the lens sets to the image sensor device.

Such a focal distance is varied with the lens set(s) design including the number and shapes of the lenses and the spacer thickness. For high optical performance (e.g. resolution) camera modules, a more complex lens set(s) design may be required, wherein the spacer thickness is reduced, when compared to conventional camera modules. As such, the total thickness of glass spacers used in high optical performance camera modules and required adhesive materials thereof plays an important role in limiting the dimension and lens set design flexibility of a high optical performance camera module. However, since the thinness of the glass spacer thickness is limited to more than 300µm and requirement for adhesive materials add to the thickness of the glass spacer, it is difficult to increase optical performance and reduce dimensions of camera modules.

Accordingly, there is a need to develop a novel camera module without the above problems.

### BRIEF SUMMARY OF THE INVENTION

A detailed description is given in the following embodiments with reference to the accompanying drawings. An embodiment of a camera module comprises an imager sensor device comprising a microlens array. A lens set overlies the imager sensor device. A first dry film type photoresist spacer is interposed between the imager sensor device and the lens set, wherein the dry film type photoresist spacer has an opening above the microlens array.

An embodiment of a method for fabricating a camera module comprises providing a lens set having a first surface and a second surface opposite thereto. A dry film type photoresist material is coated on the first surface of the lens set. The dry film type photoresist material is patterned by a photolithography process to form a spacer with an opening therein. The spacer is adhered onto an imager sensor device, such that the lens set is above the image sensor device, wherein the imager sensor device comprises a microlens array under the opening.

### BRIEF DESCRIPTION OF DRAWINGS

The invention can be more fully understood by reading the subsequent detailed description and examples with references made to the accompanying drawings, wherein:

FIGS. 1A to 1C are cross sections of an exemplary embodiment of a method for forming a lens set structure according to the invention;

FIGS. 2A to 2D are cross sections of another exemplary embodiment of a method for forming a lens set structure according to the invention;

FIG. 3 is a cross section of an exemplary embodiment of a stack lens set structure according to the invention;

FIG. 4 is a cross section of another exemplary embodiment of a stack lens set structure according to the invention; and

FIGS. 5A to 5D are cross sections of various embodiments of a camera module according to the invention.

### DETAILED DESCRIPTION OF INVENTION

The following description is of the best-contemplated mode of carrying out the invention. This description is provided for the purpose of illustrating the general principles of the invention and should not be taken in a limiting sense. The scope of the invention is best determined by reference to the appended claims.

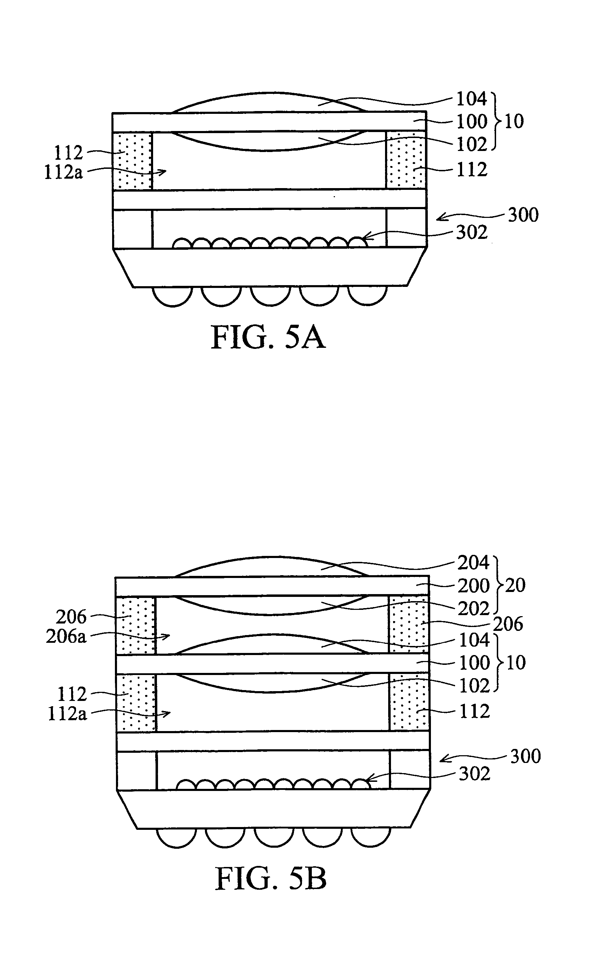

Referring to FIG. 5A, which illustrates an exemplary embodiment of a camera module according to the invention. In one embodiment, the camera module comprises an imager sensor device 300 comprising a microlens array 302, a lens set 10 is disposed overlying the imager sensor device 300, and a dry film type photoresist spacer 112 interposed between the imager sensor device 300 and the lens set 10. The imager sensor device 300, such as an image pickup or capturing device that is also referred to as a solid-state image sensor (SSIS), may be a CCD or CMOS image sensor.

The lens set 10 is disposed overlying the imager sensor device 300 through the dry film type photoresist spacer 112. In one embodiment, the lens set 10 may comprise at least one lens element which is formed of a convex or concave lens. In another embodiment, the lens set 10 may comprise at least one lens element which is formed of a convex or concave lens, and a lens substrate which is adhered to the lens element. For example, in the embodiment, the lens set 10 comprises a lens substrate 100, and two convex lens elements 102 and 104 formed on two opposite surfaces (e.g. the top surface and the bottom surface) of the lens substrate 100, respectively. The lens set 10 may comprise an organic material of glass, epoxy, acryl, or silicone.

In particular, since today's trend in camera-equipped products demands miniaturization, it requires dry film type photoresist to replace the glass in the spacer manufacturing for size reduction. Dry film type photoresist is a photosensitizing material used in photolithography to form precision patterns and provides excellent conformity that allows lamination for a multilayer configuration with the desired thickness. The seamless interfaces between dry film photoresist layers are can be achieved by selecting dry film formulation with superior adhesion and applying proper manufacturing processes. In the embodiment, the dry film type photoresist spacer 112 is employed, instead of a conventional glass spacer, to serve as a lens set support, such that the lens set 10 is spaced from the underlying image sensor device 300.

Moreover, the dry film type photoresist spacer 112 also protects the lens element 102 of the lens set 10 from damage. In the embodiment, the dry film type photoresist spacer 112 has a predetermined thickness to maintain a proper distance between the lens set 10 and the image sensor device 300. The predetermined thickness of the dry film type photoresist spacer 112 is based on the desired focal distance from the lens set 10 to the image sensor device 300. For example, the predetermined thickness of the dry film type photoresist spacer 112 is less than 300µm and greater than 30µm. Moreover, the dry film type photoresist spacer 112 is in direct contact with the lens set 10 and the image sensor 300. Namely, there is no adhesive material between the dry film type photoresist spacer 112 and the lens set 10 and between the dry film type photoresist spacer 112 and the image sensor device 300. Moreover, the dry film type photoresist spacer 112 has an opening 112a above the microlens array 302 of the image sensor device 300.

Referring to FIG. 5B, which illustrates another exemplary embodiment of a camera module according to the invention. Elements in FIG. 5B that are the same as those in FIG. 5A are labeled with the same reference numbers as in FIG. 5A and are not described again for brevity. In the embodiment, a lens set 20 is disposed overlying the lens set 10. The lens set 20 may comprise at least one lens element which is formed of a convex or concave lens. Alternatively, the lens set 20 may comprise at least one lens element which is formed of a convex or concave lens, and a lens substrate which is adhered to the lens element. For example, in the embodiment, the lens set 20 comprises a lens substrate 100, and two convex lens elements 202 and 204 formed on the top surface and the bottom surface of the lens substrate 100, respectively. Moreover, the lens set 20 may comprise a material which is the same as or similar to the lens set 10.

A dry film type photoresist spacer 206 also serves as a lens set support, such that the lens set 20 is spaced from the underlying lens set 10. Moreover, the dry film type photoresist spacer 206 protects the lens elements 102 and 202 from damage. In the embodiment, the dry film type photoresist spacer 206 also has a predetermined thickness to maintain a proper distance between the lens set 10 and the lens set 20. The predetermined thickness of the dry film type photoresist spacer 206 is based on the desired lens set(s) design. For example, the dry film type photoresist spacer 112 has a thickness of less than 300µm and greater than 30µm, and is in direct contact, without the employment of adhesive materials, with the lens set 10 and the overlying lens set 20. Moreover, the dry film type photoresist spacer 206 has an opening 206a which is substantially aligned with the opening 112a of the dry film type photoresist spacer 112.

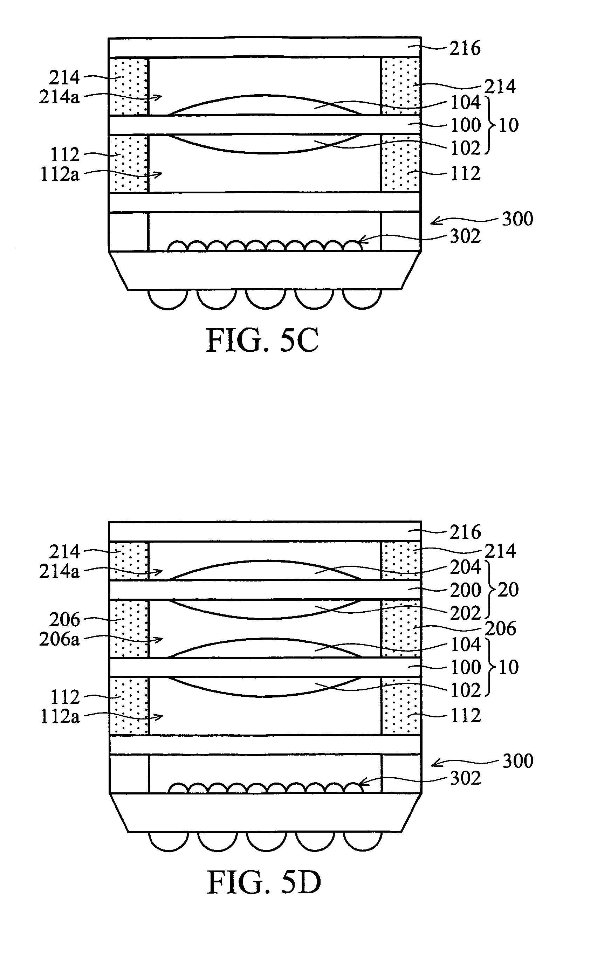

Referring to FIG. 5C, which illustrates further another exemplary embodiment of a camera module according to the invention. Elements in FIG. 5C that are the same as those in FIG. 5A are labeled with the same reference numbers as in FIG. 5A and are not described again for brevity. In the embodiment, an additional dry film type photoresist spacer 214 is disposed on the lens set 10 for protection of the uppermost lens element 104. Moreover, a transparent cover substrate 216, such as a glass, quartz, or other transparent substrates, may be optionally disposed above the lens set 10 through the dry film type photoresist spacer 214 to further protect the underlying lens set 10. The dry film type photoresist spacer 214 has an opening 214a which is substantially aligned with the opening 112a and is in direct contact with the lens set 10 and the transparent cover substrate 216.

Referring to FIG. 5D, which illustrates yet another exemplary embodiment of a camera module according to the invention. Elements in FIG. 5D that are the same as those in FIGS. 5B and 5C are labeled with the same reference numbers as in FIGS. 5B and 5C and are not described again for brevity. In the embodiment, an additional dry film type photoresist spacer 214 is disposed on the lens set 20 for protection of the uppermost lens element 204. Also, a transparent cover substrate 216 may be optionally disposed above the lens set 20 through the dry film type photoresist spacer 214 to further protect the underlying lens set 20. The dry film type photoresist spacer 214 has an opening 214a which is substantially aligned with the opening 206a and is in direct contact with the lens set 20 and the transparent cover substrate 216.

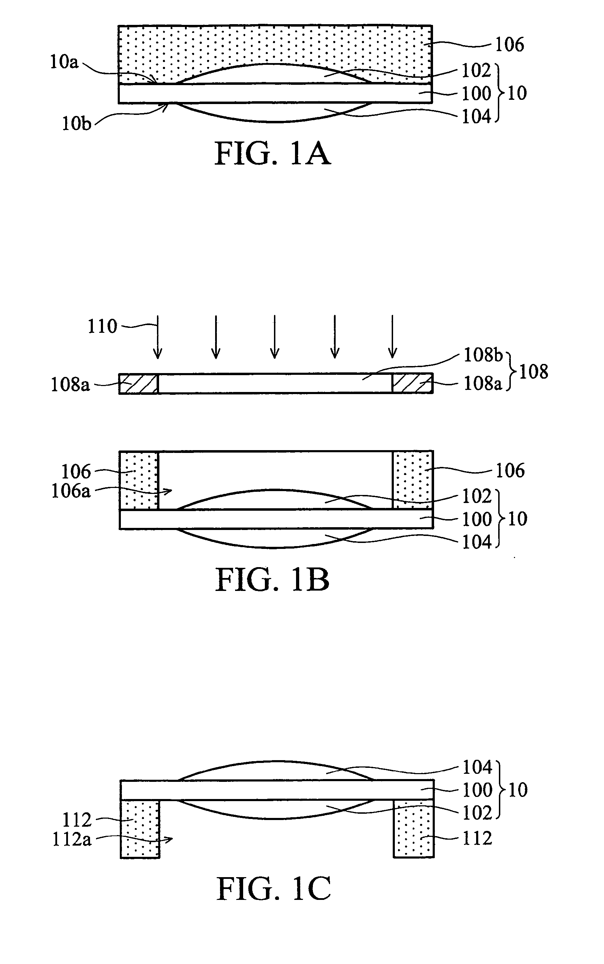

Referring to FIGS. 1A to 1C, which illustrate an exemplary embodiment of a method for forming a lens set structure according to the invention. In FIG. 1A, a lens set 10 has a surface 10a and a surface 10b is opposite to the surface 10a. The lens set 10 may comprise an organic material of glass, epoxy, acryl, or silicone. In one embodiment, the lens set 10 may comprise at least one lens element which is formed of a convex or concave lens. In another embodiment, the lens set 10 may comprise at least one lens element which is formed of a convex or concave lens, and a lens substrate which is adhered to the lens element. For example, in the embodiment, the lens set 10 comprises a lens substrate 100, and two convex lens elements 102 and 104 formed on two opposite surfaces of the lens substrate 100, respectively. Thereafter, a dry film type photoresist material 106 with a predetermined thickness is coated on the first surface 10a of the lens set 10. The dry film type photoresist material 106 may comprise a positive or negative dry film photoresist. In the embodiment, the dry film type photoresist material 106 comprises a positive dry film photoresist. The thickness of the dry film type photoresist material 106 can be adjusted by repeatedly coating thereof.

Referring to FIGS. 1B and 1C, the dry film type photoresist material 106 is patterned by a photolithography process including an exposure and development process. In FIG. 1B, an exposure process 110 is performed on the dry film type photoresist material 106 using a mask 108 that includes a spacer pattern 108a and a transmissive region 108b, to form an exposed region 106a therein and entirely cover the underlying lens element 102 of the lens set 10 through the transmissive region 108b of the mask 108. Next, a development process is performed to remove the exposed region 106a in the dry film type photoresist material 106 and then the dry film type photoresist spacer 112 with an opening 112a therein is formed in direct contact with the lens set 10, as shown in FIG. 1C. In one embodiment, the dry film type photoresist spacer 112 has a thickness of less than 300µm and greater than 30µm.

In one embodiment, a lens set structure including the lens set 10 with the dry film type photoresist spacer 112 (as shown in FIG. 1 C) is disposed above and on an imager sensor device 300 by adhering the dry film type photoresist spacer 112 onto the imager sensor device 300 using a conventional baking process, such as a hot forming process. Thereafter, the dry film type photoresist spacer 112 is in direct contact with the image sensor device 300 and a camera module is completed, in which a microlens array 302 of the imager sensor device 300 is under the opening 112a, as shown in FIG. 5A.

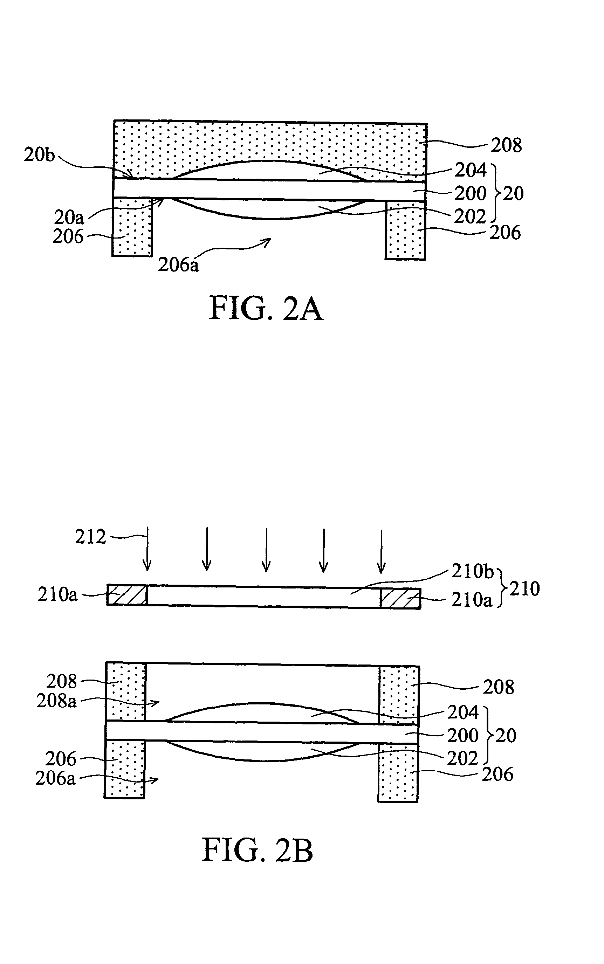

Referring to FIGS. 2A to 2D, which illustrate another exemplary embodiment of a method for forming a lens set structure according to the invention. In FIG. 2A, a lens set 20 has a surface 20a and a surface 20b is opposite to the surface 20a. The lens set 20 may comprise the same or similar materials as that of the lens set 10 shown in FIG. 1A. In one embodiment, the lens set 20 may comprise at least one lens element which is formed of a convex or concave lens. In another embodiment, the lens set 20 may comprise at least one lens element which is formed of a convex or concave lens, and a lens substrate which is adhered to the lens element. For example, in the embodiment, the lens set 20 comprises a lens substrate 200, and two convex lens elements 202 and 204 formed on two opposite surfaces of the lens substrate 200, respectively. A dry film type photoresist spacer 206 with an opening 206a therein is formed on the surface 20a of the lens set 20 by the same method for forming the dry film type photoresist spacer 112 (as shown in FIGS. 1A to 1C).

Thereafter, a dry film type photoresist material 208 with a predetermined thickness is coated on the surface 20b of the lens set 20. The dry film type photoresist material 208 may comprise the same or similar materials as that of the dry film type photoresist material 106 (as shown in FIG. 1A). In the embodiment, the thickness of the dry film type photoresist material 208 can be adjusted by repeatedly coating the dry film photoresist.

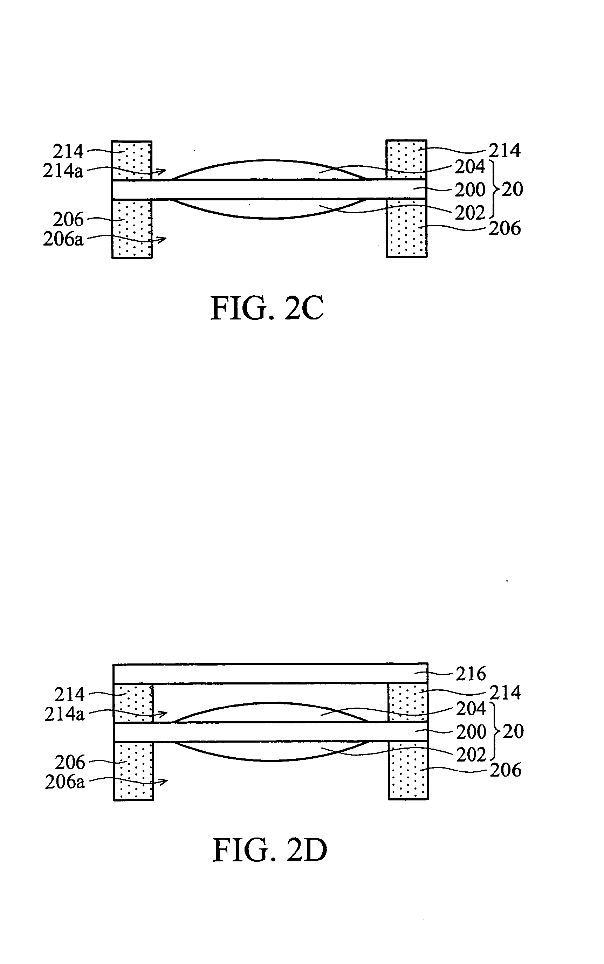

Referring to FIGS. 2B and 2C, the dry film type photoresist material 208 is patterned by photolithography. In FIG. 2B, an exposure process 212 is performed on the dry film type photoresist material 208 using a mask 210 that includes a spacer pattern 210a and a transmissive region 210b, to form an exposed region 208a therein and entirely cover the underlying lens element 204 of the lens set 20 through the transmissive region 210b of the mask 210. Next, a development process is performed to remove the exposed region 208a in the dry film type photoresist material 208 and then the dry film type photoresist spacer 214 with an opening 214a therein is formed in direct contact with the lens set 20, as shown in FIG. 2C. The opening 214a is substantially aligned to and opposite to the opening 206a.

A transparent cover substrate 216, such as a glass, quartz or other transparent substrates, is optionally adhered onto the dry film type photoresist spacer 214 by a conventional baking process, such as a hot forming process, such that the transparent cover substrate 216 is above the lens set 20 through the dry film type photoresist spacer 214 that is in direct contact with the lens set 20.

In one embodiment, a lens set structure including the lens set 10, the dry film type photoresist spacers 112 and 214 and the optional transparent cover substrate 216 may be formed by the same method for forming the lens set structure shown in FIGS. 2A to 2D. Thereafter, the lens set structure including the lens set 10, the dry film type photoresist spacers 112 and 214 and the transparent cover substrate 216 is disposed above and on an imager sensor device 300 by adhering the dry film type photoresist spacer 112 onto the imager sensor device 300 using a conventional baking process, such as a hot forming process. As a result, the dry film type photoresist spacer 112 is in direct contact with the image sensor device 300 and a camera module is completed, as shown in FIG. 5C.

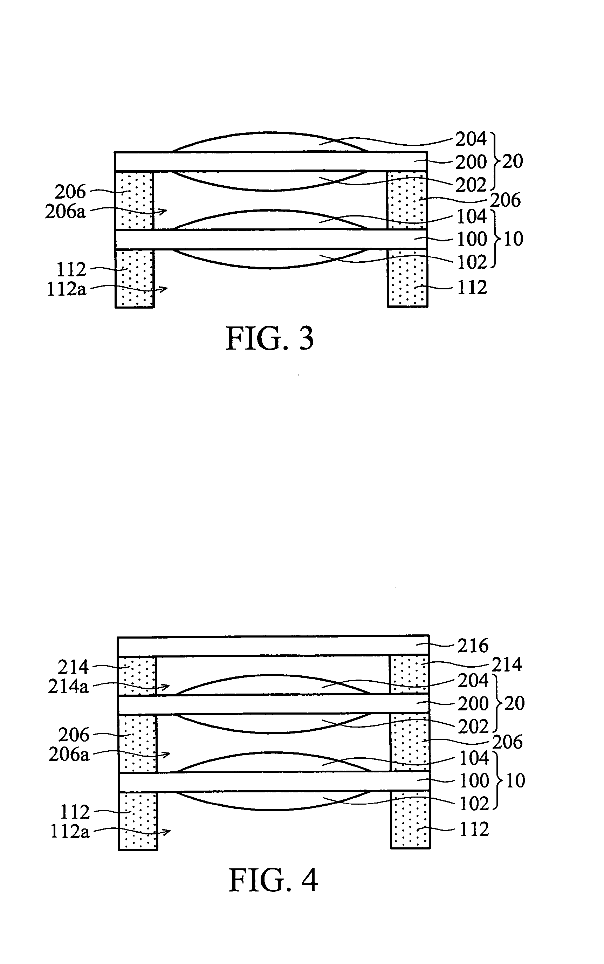

Referring to FIG. 3, which illustrates an exemplary embodiment of a stack lens set structure according to the invention. The stack lens set structure may comprises a lens set 10 with the dry film type photoresist spacer 112 and a lens set 20 with the dry film type photoresist spacer 206 vertically stacked on the lens set 10. The stack lens set structure may be formed by repeatedly performing the method shown in FIGS. 1A to 1C and at least one baking process for adhering the dry film type photoresist spacer 206 onto the lens set 10. In some embodiments, the stack lens set structure may comprise more than two lens sets and may be formed by the same or similar methods as that of forming the stack lens set structure shown in FIG. 3. In one embodiment, the stack lens set structure shown in FIG. 3 is further disposed on an imager sensor device 300 by adhering the dry film type photoresist spacer 112 onto the imager sensor device 300 using a conventional baking process, such as a hot forming process. As a result, the dry film type photoresist spacer 112 is in direct contact with the image sensor device 300 and a camera module is completed, as shown in FIG. 5B.

Referring to FIG. 4, which illustrates another exemplary embodiment of a stack lens set structure according to the invention. The stack lens set structure may comprises a lens set 10 with the dry film type photoresist spacer 112 (as shown in FIG. 1C) and a lens set 20 with the dry film type photoresist spacers 206 and 214 and an optional transparent cover substrate 216 (as shown in FIG. 2D) vertically stacked on the lens set 10. The stack lens set structure may be formed by performing the method shown in FIGS. 1A to 1C, the method shown in FIGS. 2A to 2D and at least one baking process for adhering the dry film type photoresist spacer 206 onto the lens set 10. In some embodiments, the stack lens set structure may comprise more than two lens sets and may be formed by the same or similar methods as that of forming the stack lens set structure shown in FIG. 4. In one embodiment, the stack lens set structure shown in FIG. 4 is further disposed on an imager sensor device 300 by adhering the dry film type photoresist spacer 112 onto the imager sensor device 300 using a conventional baking process, such as a hot forming process. As a result, the dry film type photoresist spacer 112 is in direct contact with the image sensor device 300 and a camera module is completed, as shown in FIG. 5D.

Note that the camera module shown in FIGS. 5A, 5B, 5C or 5D can be fabricated by a wafer level process. For example, an integrated circuit manufacturing process is performed to prepare a wafer, for example, a silicon wafer, having multiple image sensor devices 300 thereon. Also the spacer(s), the lens set(s), and the optional transparent cover substrate for each camera module can be fabricated in manifold on substrates. After stacking the substrates and the wafer having multiple image sensor devices 300, the substrates and the wafer are diced to form individual camera modules.

According to foregoing embodiments, since the spacer between the lens sets or between the lens set and the image sensor device is formed of a dry film type photoresist material and is formed by a lithography process, the fabrication of camera module can be simplified, thereby reducing manufacturing costs. Moreover, compared to the conventional glass spacer, the thickness of the dry film type photoresist spacer can be thinner (e.g. less than 300µm), thereby providing a more flexible lens set(s) design and reducing the dimension of a camera module. Namely, the optical performance of a camera module can be improved. Furthermore, since the dry film type photoresist spacer can be directly adhered to the lens set and/or the image sensor device, without the use of adhesive material, the dimensions and manufacturing costs of camera modules can be further reduced.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A camera module, comprising:
an imager sensor device comprising a microlens array;
a first lens set overlying the imager sensor device; and
a first dry film type photoresist spacer interposed between the imager sensor device and the first lens set, wherein the first dry film type photoresist spacer has a first opening above the microlens array.

2. The camera module of claim 1, wherein the first dry film type photoresist spacer has a thickness of less than 300µm and greater than 30µm.

3. The camera module of claim 1, further comprising:
a second lens set overlying the first lens set; and
a second dry film type photoresist spacer interposed between the first lens set and the second lens set, wherein the second dry film type photoresist spacer has a second opening which is substantially aligned with the first opening.

4. The camera module of claim 3, wherein the second dry film type photoresist spacer has a thickness of less than 300µm and greater than 30µm.

5. The camera module of claim 3, further comprising a third dry film type photoresist spacer on the second lens set, wherein the third dry film type photoresist spacer has a third opening substantially aligned with the first and second openings.

6. The camera module of claim 5, further comprising a transparent cover substrate overlying the second lens set, such that the third dry film type photoresist spacer is interposed between and in direct contact with the second lens set and the transparent cover substrate.

7. The camera module of claim 1, further comprising a second dry film type photoresist spacer on the first lens set, wherein the second dry film type photoresist spacer has a second opening substantially aligned with the first opening.

8. The camera module of claim 7, further comprising a transparent cover substrate overlying the second lens set, such that the second dry film type photoresist spacer is interposed between and in direct contact with the first lens set and the transparent cover substrate.

9. A method for fabricating a camera module, comprising:
providing a first lens set having a first surface and a second surface opposite thereto;
coating a first dry film type photoresist material on the first surface of the first lens set;
patterning the first dry film type photoresist material by a photolithography process to form a first spacer with a first opening therein; and
adhering the first spacer onto an imager sensor device, such that the first lens set is above the image sensor device,
wherein the imager sensor device comprises a microlens array under the first opening.

10. The method of claim 9, wherein the first spacer has a thickness of less than 300µm and greater than 30µm.

11. The method of claim 9, further comprising:
providing a second lens set having a third surface and a fourth surface opposite thereto;
coating a second dry film type photoresist material on the third surface of the second lens set;
patterning the second dry film type photoresist material by a photolithography process to form a second spacer with a second opening therein; and
adhering the second spacer onto the second surface of the first lens set, such that the second lens set is above the first lens set,
wherein the second opening is substantially aligned with the first opening.

12. The method of claim 11, wherein the second spacer has a thickness of less than 300µm and greater than 30µm.

13. The method of claim 11, further comprising:
coating a third dry film type photoresist material on the fourth surface of the second lens set; and
patterning the third dry film type photoresist material by a photolithography process to form a third spacer with a third opening therein, wherein the third opening is substantially aligned with the first and second openings.

14. The method of claim 13, further comprising a step of adhering a transparent cover substrate onto the third spacer, such that the transparent cover substrate is above the second lens set, wherein the third spacer is in direct contact with the second lens set and the transparent cover substrate.

15. The method of claim 11, further comprising:
coating a second dry film type photoresist material on the second surface of the first lens set; and
patterning the second dry film type photoresist material by a photolithography process to form a second spacer with a second opening therein,
wherein the second opening is substantially aligned with the first opening; and
adhering a transparent cover substrate onto the second spacer, such that the transparent cover substrate is above the first lens set,
wherein the second opening is substantially aligned with the first opening and the second spacer is in direct contact with the first lens set and the transparent cover substrate.
